# EUROPEAN PATENT APPLICATION

(11) **EP 4 514 074 A1**
(43) Date of publication of application: **26.02.2025**
(21) Application number: 23192916.7
(22) Date of filing: 23.08.2023
(51) Int. Cl.: H05K 1/02, H05K 3/00, H05K 3/28, H05K 1/09, H05K 1/18, H05K 3/12, H05K 3/14

(54) **METHOD FOR PRINTING AN ELECTRICALLY CONDUCTIVE LAYER ON A SURFACE OF 3D ELECTRONIC ASSEMBLY AND ASSOCIATED 3D ELECTRONIC ASSEMBLY**

(71) Applicant: Heraeus Electronics GmbH & Co. KG, 63450 Hanau (DE)
(72) Inventor: Chang, Ming Hung, 30288 Zhubei City (TW); Stadnik, Alan Paul, 63450 Hanau (DE); Huang, Wei-Po, 30288 Zhu-Bei City (TW); Reinstädt, Markus, 63450 Hanau (DE); Sternkiker, Christoph, 63450 Hanau (DE); Wu, Hui Hsien, 30288 Zhu-Bei City (TW)
(74) Representative: Heraeus IP

(57) **Abstract**

The present invention relates to method for for depositing an electrically conductive layer on a surface of a three-dimensional (3D) electronic assembly 10A, 10B, 10C comprising at least one electronic device 14 embedded in a solid polymer material 16. The method comprises the steps of (i) providing a 3D electronic assembly 10A, 10B, 10C, (ii) forming at least one flow barrier 18 in the surface of the solid polymer material 16 of the 3D electronic assembly 10A, 10B, 10C, and (iii) depositing an electrically conductive layer 20A, 20B, 20C on at least a portion of the surface of the solid polymer material 16, such that the electrically conductive layer 20A, 20B, 20C is at least partially delimited by the flow barrier 18. The present invention also relates to an associated 3D electronic assembly 10A, 10B, 10C.

## Description

The present invention relates to a method for depositing an electrically conductive layer on a surface of a 3D electronic assembly, such as a System-in-Package (SIP). In addition, the present invention relates to a 3D electronic assembly.

Insulating and protecting electronic components or even complete electronic circuits, such as for example a System-in-Package (SIP), in polymeric encapsulants is a common technique today. Polymeric encapsulants may, for example, comprise molding compounds or more specifically epoxy molding compounds. Due to the high density of the electrical functions built into a complete electronic circuit, electromagnetic or electrical interference (EMI) may cause complete failure of the electronic circuit. To this end, these electronic circuits have to be shielded to both inhibit EMI radiation to emanate from and to be received by the electronic circuit.

Traditionally, SIP modules, for example, use a metal housing for the purpose of EMI shielding. A metal housing, however, counterfeits the objective of miniaturization. Instead of using a metal housing, a functional layer can be applied, for example by a PVD process. Alternatively, for example, a silver containing inkjet ink can be deposited on the surface of a SIP module using an inkjet printer. Once the inkjet ink is printed on the surface of the SIP module, the inkjet ink is cured using, for example, UV light in order to form a continuous functional layer on the surface of the SIP module. Other means for curing are conceivable, such as oven-curing, IR-radiation or plasma. Prior to the printing process, the surface of the SIP module may undergo a pretreatment process for cleaning purposes. Again, plasma may be used to this end.

US 2021/227697 A1 and US 2015/068787 A1 disclose the generation of a groove by laser ablation and filling the groove with conductive material, for example conductive ink, thus resulting in precisely contoured tracks of a printed circuit board, for example.

US 2012/055013 A1 relates to laser ablation of selected areas in order to generate, for example, an antenna by depositing silver ink into the ablated areas.

When inkjet-printing an electrically conductive ink on the surface of a 3D electronic assembly, such as for example a SIP module, the ink tends to flow downwards on tilted or vertical surfaces due to gravity. This problem may be mitigated by applying only thin layers at a time, and to repeat the printing process several times in order to achieve a sufficient layer thickness. However, the edges of the printed layer tend to not be precisely defined. Instead, they exhibit a wavy shape, as a result of which the ink layer cannot be printed in close proximity of conductive components of the 3D electronic assembly. A safety margin has to be observed in order to prevent electrical short circuits. In addition, printing on surfaces that are not plane-parallel to the print head of an inkjet printer also results in imprecise and wavy print edges.

It is an object of the present invention to provide a method for depositing an electrically conductive layer on a surface of a 3D electronic assembly, such as for example a SIP, which mitigates or overcomes the drawbacks of prior art methods. In particular, it is an object of the present invention to improve the sharpness of the edges of the deposited electrically conductive layer, in particular when depositing the layer by means of an inkjet printer or spray coater.

These objects are solved by the subject-matter of independent claims 1 and 10. Optional and preferred features of the present invention are subject of the dependent claims.

The present invention is generally suitable for depositing any sort of electrically conductive layer (or electrically conductive print pattern) on a 3D electronic assembly. The electrically conductive layer may be any sort of layer. The layer, when being applied, preferably achieves an EMI shielding function from electromagnetic interference (EMI) caused by electromagnetic induction or electromagnetic radiation emitted from an electronic device within the 3D electronic assembly or from an external source. The layer, however, may preferably also be formed such that it performs the function of an antenna in an Antenna-in-Package (AIP).

The electrically conductive layer may be composed of a conductive ink which is a type of ink that, when being printed and preferably cured, produces electrically conductive properties. Examples of such types of ink are a silver, gold, titanium, bismuth, nickel, chrome or copper ink or a silver, gold, titanium, bismuth, nickel, chrome or copper containing ink, preferably an ink containing metal organic decomposition (MOD) compounds, also known as MOD ink. The conductive ink may also be of a type which includes conductive particles, for example silver, gold, titanium, bismuth, nickel, chrome or copper particles.

In order for the conductive ink to act as an EMI shield, for example, printing must be performed such that the conductive ink forms a continuous layer on at least portions of the exposed surfaces of the 3D electronic assembly with no gaps larger than a quarter wavelength of the frequency of the external or internal electromagnetic radiation which is to be blocked.

The electrically conductive layer may also include a non-conductive layer, such as a protection layer, which protects the conductive layer underneath the protection layer from damage and/or other adverse environmental influences, such as excessive heat and corrosion inducing substances, for example oxygen.

Using the method according to the present invention, the electrically conductive layer may be deposited only on certain portions or on the entire exposed surface(s) of the 3D electronic assembly, and the layer thickness can selectively be manipulated such that it varies or is highly uniform and homogenous throughout the deposited portions of the exposed surface(s) of the 3D electronic assembly. The final layer thickness, of course depending on the absolute thickness value, may be achieved in one or several subsequent deposition steps. Thus, highly effective electrically conductive layers can be achieved with properties that may specifically be adapted to user needs and requirements.

SIPs are preferably used in the method of the present invention. However, in general, any 3D electronic assembly that needs to be at least partially covered by an electrically conductive layer may be used in the method of present invention, such as for example an AlP. The shape of the 3D electronic assembly may be a cube or a cuboid, for example.

The present invention can in principle be employed in any digital printing process, preferably digital inkjet printing process, by means of which conductive and non-conductive coatings (layers, print patterns) can be deposited with a selectively adjustable thickness, high structural uniformity and homogeneity and high throughput.

Inkjet printers are generally known and may have different set-ups specifically adapted to user requirements. The method of the present invention is carried out using preferably an inkjet printer with one or more print heads. Each print head has a multiplicity of print nozzles which are arranged in a print nozzle plane. The printing width of a print head used in the method of the present invention may be selected depending on the size of the 3D electronic assembly, for example 30,5 cm (12 inch) and larger.

Once the printed electrically conductive layer is cured, a functional layer is obtained which preferably exhibits an EMI shielding function. For example, curing may be accomplished by using UV light. Other means for curing are also conceivable, such as oven-curing, IR-radiation or plasma. Prior to the printing process, the surface of the 3D electronic assembly may undergo a pretreatment process for cleaning purposes, e.g., by using plasma.

After each or a predetermined number of printing steps, the electrically conductive layer may be cured. If an ink is used which requires crosslinking, the crosslinked ink may further undergo a chemical reduction step as a result of which metal in the form of nanoparticles will precipitate. Any solvent will evaporate, and the printed ink will be sintered. The curing step is understood to include all of these chemical processes which occur in particular types of ink.

A first aspect of the invention relates to a method for depositing an electrically conductive layer on a surface of a three-dimensional (3D) electronic assembly, comprising at least one electronic device embedded in a solid polymer material, The method of the present invention comprises the steps of (i) providing a 3D electronic assembly, (ii) forming at least one flow barrier in the surface of the solid polymer material of the 3D electronic assembly, and (iii) depositing an electrically conductive layer on at least a portion of the surface of the solid polymer material, such that the electrically conductive layer is at least partially delimited by the at least one flow barrier.

Preferably, the at least one flow barrier is formed on a non-horizontal and/or non-planar surface, preferably a vertical surface, of the solid polymer material, when the 3D electronic assembly is placed on a horizontal surface.

More preferably, the at least one flow barrier is a continuous ring-shaped flow barrier extending completely around the solid polymer material.

It is advantageous, if the at least one flow barrier is a recess.

According to a preferred embodiment of the present invention, the at least one recess is formed by laser ablation or sawing or milling or embossing.

Preferably, the at least one recess has a depth in a range of 5-50 µm, and a width and depth in a range of 5-50 um.

More preferably, the method further comprises the step of laser-marking the 3D electronic assembly, wherein the laser for laser-marking the 3D electronic assembly is also used for forming the at least one recess.

Yet more preferably, the step of depositing the electrically conductive layer is carried out by inkjet printing or spray coating.

It is advantageous if the electrically conductive layer is an electromagnetic interference shielding covering the at least one electronic device, and wherein the electrically conductive layer is printed using a conductive ink.

A second aspect of the present invention relates to a three-dimensional (3D) electronic assembly comprising at least one electronic device embedded in a solid polymer material, wherein the 3D electronic assembly includes at least one flow barrier in the surface of the solid polymer material, and wherein an electrically conductive layer is provided on at least a portion of the surface of the solid polymer material, such that the electrically conductive layer is at least partially delimited by the at least one flow barrier.

It is preferred if the at least one flow barrier is provided on a non-horizontal and/or non-planar surface, preferably a vertical surface, of the solid polymer material, when the 3D electronic assembly is placed on a horizontal surface.

It is even more preferred, if the at least one flow barrier is a continuous ring-shaped flow barrier extending completely around the solid polymer material.

Advantageously, the at least one flow barrier is formed as a recess.

Yet even more advantageously, the at least one recess has a depth in a range of 5-50 µm, and a width in a range of 5-50 um.

According to a preferred embodiment of the invention, a layer thickness of the electrically conductive layer is in a range of 0,0001 µm to 100 µm, preferably is in a range of 1 µm to 4 µm. Preferably, the electrically conductive layer is an electromagnetic interference shielding covering the at least one electronic device, and wherein the electrically conductive layer comprises a conductive ink, preferably containing or consisting of silver, gold, titanium, bismuth, nickel, chrome or copper.

Even more preferably, in the method of the first aspect of the invention or in the 3D electronic assembly of the second aspect of the invention, the 3D electronic assembly is a System-in-Package (SIP) or Antenna-in-Package (AIP) and the solid polymer material is a molding compound.

The above features of the first and the second aspect of the invention may be combined in any way, and thus the present invention is not limited to the combination of features described below with reference to the preferred embodiments of the invention.

The present invention will now be described by way of example using the attached drawing figures. The drawing figures are for illustrative purposes and serve only to provide exemplary embodiments of the invention. The drawing figures in no way limit the present invention, but merely represent a preferred embodiment thereof.
- Fig. 1: shows a conventional Standard-in-Package (SIP);
- Fig. 2: shows a SIP according to a preferred embodiment of the invention;
- Fig. 3: shows another SIP according to another preferred embodiment of the invention; and
- Fig. 4: shows a further SIP according to yet another preferred embodiment of the invention.

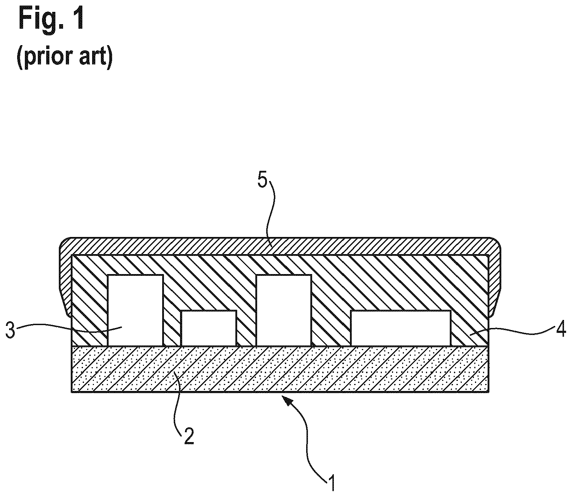

It is again pointed out that the present invention may be applicable to any sort of 3D electronic assembly having at least one electronic device embedded or encapsulated within a polymeric material, despite the preferred embodiments being described below and shown in Fig. 1 to Fig. 4 are in relation to a Standard-in Package (SIP).

In the description below as well as in Fig. 1 to Fig. 4, same reference numerals indicate same or technically like parts in all embodiments.

Fig. 1 shows an exemplary conventional SIP 1 which includes a number of electronic devices 3, such as integrated circuits, positioned on a substrate 2. The substrate 2 gives the SIP 1 sufficient rigidity. The electronic devices 3 are embedded in a polymeric molding compound 4, such as an epoxy. In order to electromagnetically shield the electronic devices 3 from electromagnetic interference (EMI) caused by electromagnetic induction or electromagnetic radiation, a electrically conductive layer (print pattern) 5 is applied on selective portions of the surface of the polymeric molding compound 4. In the example shown in Fig. 1, the electrically conductive layer 5 is deposited over the entire top surface and at portions on both sidewalls of the more or less cube-shaped polymeric molding compound 4.

The electrically conductive layer is conventionally printed, using preferably an inkjet printer, on the polymeric molding compound. As high viscosity inks are difficult to process by inkjet printing, low viscosity inks are the first choice for the electrically conductive layer. Due to gravity, the low viscosity ink tends to flow downward due to gravity, thus yielding a non-uniform, imprecise and wavy edge(s) of the electrically conductive layer. As a result of the wavy (fuzzy) edge(s), the layer thickness of the electrically conductive layer varies. In particular, the layer thickness near the edges on the sidewalls tends to be smaller than elsewhere, as a result of which EMI shielding is inferior in those areas where the layer thickness is thinner. The thickness devation of the wavy (fuzzy) edges tends to become larger if several layers of ink are printed.

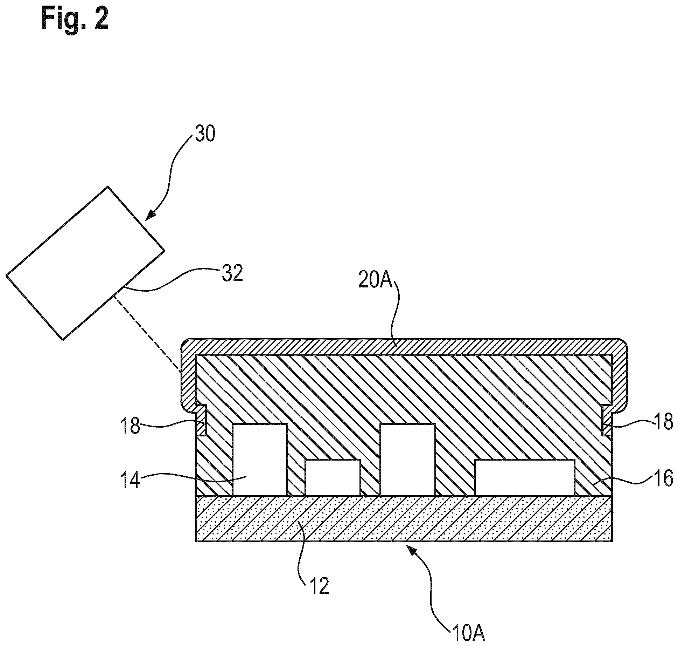

To mitigate or even eliminate this problem, Fig. 2 shows a SIP 10A according to a preferred embodiment of the invention. As in Fig. 1, a number of electronic devices 14 is positioned on a substrate 12 and is embedded in a polymeric molding compound 16. An electrically conductive (functional) layer 20A is deposited on the top surface of the polymeric molding compound 16 and on portions at the sidewalls of the polymeric molding compound 16. To improve the edge sharpness of the electrically conductive layer at the sidewalls, a recess 18 is formed on a part or all vertical sidewalls which acts as a flow barrier for the ink. The recess 18 may preferably extend continuously, i.e., without any interruptions or gaps, around the circumference of the polymeric molding compound 16. Wet ink may flow into the recess 18, and may accumulate therein until the ink has sufficiently cured, from which point the ink may no longer flow downward due to gravity, thus yielding a precise and sharp edge(s) of the electrically conductive layer 20A. Note that depending on the type of ink, the layer thickness to be printed and other processing parameters, the wet ink may not flow into the recess, but instead stops short before reaching the bottom of the recess. In that case, the edge sharpness will be improved as well.

Fig. 2 also shows a print head 30 of an inkjet printer with a number of print nozzles (not shown) positioned in a print nozzle plane 32.

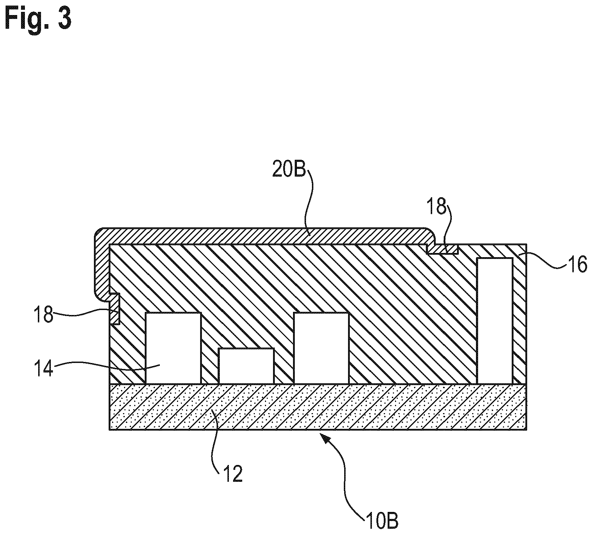

Fig. 3 shows another SIP 10B according to another preferred embodiment of the invention which differs, *inter alia,* from the SIP 10A of Fig. 2 in that the electrically conductive layer 20B is deposited only on a portion of the top surface of the polymeric molding compound 16. Again, a recess 18 is formed at one vertical sidewall, preferably three vertical sidewalls, of the polymeric molding compound 16 and another recess 18 is formed on the top surface of the polymeric molding compound 16 in order to prevent the ink from flowing into areas on the top surface of the molding compound 16 which are not to be covered by ink. The recess 18 at the sidewalls may preferably extend continuously along all three sidewalls of the polymeric molding compound 16. However, it may also extend along only one sidewall of the polymeric molding compound 16, thus leaving three sidewalls of the cuboidal polymeric molding compound 16 free of a recess 18.

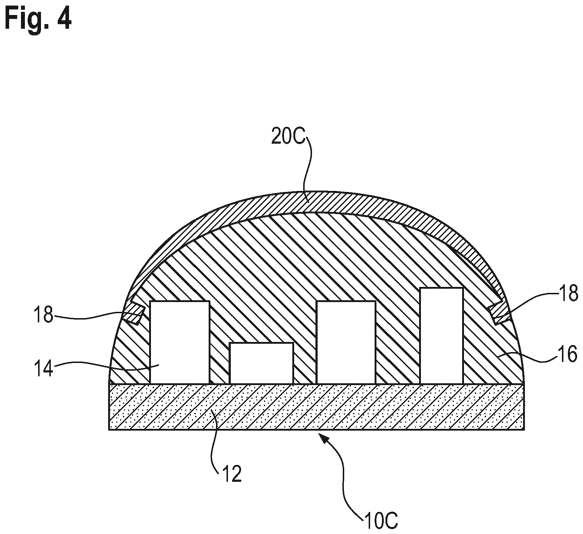

With reference to Fig. 4, an SIP 10C with a dome-shaped polymeric molding compound 16 is shown. A electrically conductive layer 20C is printed using a conductive ink on the non-planar top surface of the dome-shaped molding compound 16. The electrically conductive layer 20C is delimited by a recess 18 provided near the bottom of the dome-shaped molding compound 16 in proximity of the substrate 12. The recess 18 prevents the ink from flowing into areas which are not to be covered by the ink. The recess 18 may preferably extend continuously, i.e., without any gaps, around the circumference of the dome-shaped polymeric molding compound 16.

In general, at least one, i.e., one or more flow barrier 18 may be formed in the polymeric molding compound 16 at selected positions. The at least one flow barrier may be a recess 18 or a not-shown platform (shoulder) both of which may be structured such to prevent ink from flowing into areas which are not to be covered by the ink. The at least one recess 18 may preferably have the form of a trench with a planar bottom and two sidewalls extending perpendicularly from the bottom. The depth of the at least one recess may be in a range of 5-50 µm, and the width of the at least one recess 18 may be in a range of 5-50 µm. The depth and or the width of the at least one recess 18 may vary along its length. The invention is not limited to a particular shape of the recess 18. Instead, it is conceivable that the recess 18 may have any shape, such as symmetrical and assymetrical shapes in a vertical or horizontal cross-section. The recess 18 may be arcuate, half-circular, polygonial or V-shaped, for example. The at least one recess 18 may be continuous, in that it is ring-shaped with no gaps in between and with no free ends. The at least one recess 18 may extend all the way around the circumference of the polymeric molding compund 16.

In all preferred embodiments of the invention, the electrically conductive layers 20A, 20B, 20C are at least partially delimited by the at least one recess 18. Delimited in this context may be interpreted such that the upstream edge, seen in the flow direction of the ink, defines the edge of the electrically conductive layers 20A, 20B, 20C. Hence, irrespective of whether the ink has completely or even only partially filled the at least one recess 18, the edge sharpness of the electrically conductive layers 20A, 20B, 20C is improved. The at least one recess 18 may be formed, for example, by laser ablation, sawing, milling, and embossing.

Preferably, the at least one recess 18 may be formed by the same laser that is used for marking the 3D electronic assembly. For that purpose, an infrared laser having an emission wavelength of 1064 nm may be used. However, other types of lasers may be employed for that purpose as well, such as a green laser with an emission wavelength of 532 nm. When using an infrared laser, for example, the scanning speed of the laser may be 350-1350 mm/s, the frequency may be 10-200 Hz and the power of the infrared laser may be in a range of 20 mW to 100 W.

Low viscosity conductive ink on a non-horizontal wall flows down due to gravity. According to the invention, the flow of ink is stopped prior to curing by the recess to create a sharp and well defined edge. The recess may be partly or fully filled with ink, thus yielding a layer thickness in the recess which is higher than outside the recess. In an ideal situation, the ink does not flow over the recess, as a result of which the printed edge of the ink is relatively sharp and waviness, which exists in the prior art, is reduced.

In the prior art, where no recess is formed into the polymeric molding compound, the edge of the electrically conductive layer may vary by 150 µm, whereas with the invention, where a recess is formed at selected portions of the polymeric molding compund, the edge of the electrically conductive layer after curing may vary only by 50 µm. Due to this reduced waviness of the edge, a more homogeneous layer thickness can be achieved throughout the electrically conductive layer.

The waviness may be measured using a suitable imaging technique, for example a microscope or an automatic optical inspection (AOI) system. For example, an average waviness may be determined by measuring the distance between peaks and troughs of the wavy edge of the electrically conductive layer relative to a reference position, preferably the printer setting where the edge should ideally be, and averaging the measured values of a number of printed 3D electronic assemblies, for example 400, thus obtaining an average value of the waviness of the printed edge of the electrically conductive layer. An average value may also be obtained for each surface of the polymeric molding compound, e.g., four average values may be obtained for a cuboidal polymeric molding compound.

A thickness of the electrically conductive layer is preferably in a range of 0,0001 µm to 100 µm, more preferably in a range of 0,001 µm to 50 µm, yet more preferably in a range of 0,1 µm to 5 µm, and even yet more preferably in a range of 1 µm to 4 µm.

Although the preferred embodiments of the invention, as shown in Fig. 2 to Fig. 4, have been described in relation to SIPs, the invention may also be applied to AlPs. The antenna, which is preferably meandering on the dome-shaped surface of the polymeric encapsulant of the AlP, may be formed with precise antenna edges by creating two spaced-apart recesses that define a raised polymer hill in between. The neighbouring (inwardly positioned) edges of the two recesses then define the width of the antenna. Edge sharpness of the antenna is critical in terms of frequency accuracy of the antenna.

## Claims

1. Method for depositing an electrically conductive layer on a surface of a three-dimensional (3D) electronic assembly (10A, 10B, 10C)comprising at least one electronic device (14) embedded in a solid polymer material (16), the method comprising the steps of:
- providing a 3D electronic assembly (10A, 10B, 10C);
- forming at least one flow barrier (18) in the surface of the solid polymer material (16) of the 3D electronic assembly (10A, 10B, 10C);
- depositing an electrically conductive layer (20A, 20B, 20C) on at least a portion of the surface of the solid polymer material (16), such that the electrically conductive layer (20A, 20B, 20C) is at least partially delimited by the at least one flow barrier (18).

2. Method according to claim 1, wherein the at least one flow barrier (18) is formed on a non-horizontal and/or non-planar surface, preferably a vertical surface, of the solid polymer material (16), when the 3D electronic assembly (10A, 10B, 10C) is placed on a horizontal surface.

3. Method according to claim 1 or 2, wherein the at least one flow barrier (18) is a continuous ring-shaped flow barrier (18) extending completely around the solid polymer material (16).

4. Method according to any one of the preceding claims, wherein the at least one flow barrier is a recess (18).

5. Method according to claim 4, wherein the at least one recess (18) is formed by laser ablation or sawing or milling or embossing.

6. Method according to any one of claims 4 or 5, wherein the at least one recess (18) has a depth in a range of 5-50 µm, and a width in a range of 5-50 µm.

7. Method according to any one of claims 4 to 6, further comprising the step of laser-marking the 3D electronic assembly (10A, 10B, 10C), wherein the laser for laser-marking the 3D electronic assembly (10A, 10B, 10C) is also used for forming the at least one recess (18).

8. Method according to any one of the preceding claims, wherein the step of depositing the electrically conductive layer is carried out by inkjet printing or spray coating.

9. Method according to any one of the preceding claims, wherein the electrically conductive layer (20A, 20B, 20C) is an electromagnetic interference shielding (20A, 20B, 20C) covering the at least one electronic device (14), and wherein the electrically conductive layer (20A, 20B, 20C) is printed using a conductive ink.

10. A three-dimensional (3D) electronic assembly (10A, 10B, 10C) comprising at least one electronic device (14) embedded in a solid polymer material (16), wherein the 3D electronic assembly (10A, 10B, 10C) includes at least one flow barrier (18) in the surface of the solid polymer material (16), and wherein an electrically conductive layer (20A, 20B, 20C) is provided on at least a portion of the surface of the solid polymer material (16), such that the electrically conductive layer (20A, 20B, 20C) is at least partially delimited by the at least one flow barrier (18).

11. The 3D electronic assembly (10A, 10B, 10C) according to claim 10, wherein the at least one flow barrier (18) is provided on a non-horizontal and/or non-planar surface, preferably a vertical surface, of the solid polymer material (16), when the 3D electronic assembly (10A, 10B, 10C) is placed on a horizontal surface.

12. The 3D electronic assembly (10A, 10B, 10C) according to claim 10 or 11, wherein the at least one flow barrier (18) is a continuous ring-shaped flow barrier (18) extending completely around the solid polymer materialmolding (16).

13. The 3D electronic assembly (10A, 10B, 10C) according to any one of claims 10 to 12,
wherein the at least one flow barrier (18) is formed as a recess (18).

14. The 3D electronic assembly (10A, 10B, 10C) according to claim 13, wherein the at least one recess (18) has a depth in a range of 5-50 µm, and a width in a range of 5-50 µm.

15. The 3D electronic assembly (10A, 10B, 10C) according to any one of claims 10 to 14, wherein a layer thickness of the electrically conductive layer (20A, 20B, 20C) is in a range of 0,0001 µm to 100 µm, preferably in a range of 1-4 µm.

16. The 3D electronic assembly (10A, 10B, 10C) according to any one of claims 10 to 15, wherein the electrically conductive layer (20A, 20B, 20C) is an electromagnetic interference shielding (20A, 20B, 20C) covering the at least one electronic device (14), and wherein the electrically conductive layer (20A, 20B, 20C) comprises a conductive ink.

17. The method according to any one of claims 1 to 9 or the 3D electronic assembly according to any one of claims 10 to 16, where the 3D electronic assembly is a System-in-Package (SIP) or Antenna-in-Package (AlP), and the solid polymer material is a molding compound.
